# EUROPÄISCHE PATENTSCHRIFT

(11) **EP 3 789 782 B1**
(45) Veröffentlichungstag und Bekanntmachung des Hinweises auf die Patenterteilung: **08.11.2023**
(21) Anmeldenummer: 19195513.7
(22) Anmeldetag: 05.09.2019
(51) Int. Cl.: G01R 31/69, G01R 31/67, H01B 13/012

(54) **MODULARES PRÜFSYSTEM UND VERFAHREN ZUR AUTOMATISIERTEN PRÜFUNG UNTERSCHIEDLICHER VARIANTEN VON KABELBÄUMEN**
MODULAR TESTING SYSTEM AND METHOD FOR AUTOMATICALLY TESTING DIFFERENT VARIANTS OF CABLE HARNESSES
SYSTÈME D'ESSAI MODULAIRE ET PROCÉDÉ D'ESSAI AUTOMATISÉ DES DIFFÉRENTES VARIATIONS DE FAISCEAUX DE CÂBLES

(43) Veröffentlichungstag der Anmeldung: 10.03.2021
(73) Patentinhaber: Lisa Dräxlmaier GmbH, 84137 Vilsbiburg (DE)
(72) Erfinder: Giftthaler, Konrad, 84036 Hohenegglkofen (DE); Kagerhuber, Manuel, 84140 Gangkofen (DE); Fußeder, Franz, 84140 Gangkofen (DE)

(56) Entgegenhaltungen:
- WO-A1-01/79871
- JP-A- 2001 324 531
- US-A- 5 072 185
- US-B1- 7 112 969

## Beschreibung

### Technisches Gebiet

Die vorliegende Erfindung betrifft ein modulares Prüfsystem und ein Verfahren zur automatisierten Prüfung unterschiedlicher Varianten von Kabelbäumen.

### Stand der Technik

Bei Kabelbäumen handelt es sich üblicherweise um eine Zusammenfassung von einzelnen Leitungen zu Bündeln. Über diese Leitungen werden in einem damit ausgerüsteten Fahrzeug Signale und/oder elektrische Energie übertragen. Ein solcher Kabelbaum kann verschiedene Abzweigungen, beispielsweise in Form von Kreuzungen von einzelnen Leitungen, und Steckverbinder zum Anbinden des Kabelbaums in einem Fahrzeug umfassen. Stellen- oder abschnittsweise werden die einzelnen Leitungen beispielsweise durch Gewebebänder, Schellen, Kabelbinder oder Schläuche zu einem Kabelstrang zusammengefasst. Häufig sind diese Kabelbäume kundenspezifisch konfiguriert, so dass eine Vielzahl unterschiedlicher Kabelbaumvarianten zu fertigen ist.

Üblicherweise erfolgt die Herstellung bzw. Fertigung eines solchen Kabelbaums auf einem horizontal angeordneten Baubrett. Auf diesem Baubrett sind oftmals mehrere aufrechtstehende Auflagegabel angeordnet, wobei einzelne Leitungen auf ihrem Weg von einem Start- zu einem Zielsteckverbinder in die Auflagegabeln eingehängt werden, um sie darin zu einem Kabelstrang zusammenzufassen.

Auf derartigen Baubrettern hergestellte Kabelbäume werden üblicherweise am Ende einer Produktionslinie manuell abgenommen und beispielsweise in Transportboxen oder mit Hilfe von Handlingsystemen zu einer Prüfstation befördert. An der Prüfstation angekommen muss der Kabelbaum üblicherweise ausgebreitet und manuell an entsprechenden Schnittstellen bzw. Prüfanschlüssen der Prüfstation aufgesteckt werden. Die Handhabung und Prüfung von Kabelbäumen ist also relativ aufwendig.

JP 2001 324531 A zeigt mehrere Prüfgeräte, die parallel zu einzelnen Steckern eines Kabelbaums angeordnet sind, welche wiederum von mehreren Gehäuseempfängern gehalten werden. Zudem weist das Prüfgerät mehrere mehrstufig übereinander angeordnete Prüfwerkzeugeinheiten auf, die sich voneinander unterscheiden. Die Prüfwerkzeugeinheiten innerhalb der Prüfgeräte können durch ein erstes Antriebsmittel angehoben oder abgesenkt werden, sodass dann eine Reihe ausgewählter Prüfwerkzeugeinheiten durch ein zweites Antriebsmittel gegen die Stecker in den Gehäuseempfängern bewegt werden kann, um die Funktionalität letzterer zu überprüfen.

US 5 072 185 A zeigt ein herkömmliches Testsystem zum Prüfen eines auf einem Brett angeordneten Kabelbaumes. Die individuellen Stecker des Kabelbaums werden jeweils mit Adaptern gekoppelt. Dazu weißen diese Adapter einerseits Kabelbaumseitige erste Stecker auf, die der Konnektierung mit den Steckern des Kabelbaums dienen, zweite Stecker, die der Konnektierung mit einem Universal-Schnittstellenmodul dienen und Kabeln zwischen diesen beiden Steckern auf.

WO 01/79871 A1 zeigt ein Verfahren und eine Einrichtung zum Prüfen von Kabelbäumen, wobei die elektrischen und pneumatischen Funktionen, die zum Betreiben eines Testmoduls notwendig sind, für jedes Testmodul jeweils durch eine dezentrale intelligente Modulsteuereinheit realisiert werden, die einerseits mit dem jeweiligen Testmodul und andererseits mit dem Steuerrechner sowie der Pneumatikzuleitung verbunden ist.

US 7 112 969 B1 zeigt ein automatisches Kabeltestsystem umfassend Adaptermodule, die einen zu prüfenden Kabelbaum mit einem Schnittstellentestadapter verbinden. Der Schnittstellentestadapter (ITA) ist an eine automatische Kabeltestmaschine gekoppelt oder in diese integriert. Der ITA verfügt über eine Platte, in die ein standardisierter Stecker in einer beliebigen Position eingesteckt werden kann. Die von den Prüfpunkten der Kabelprüfmaschine ausgehenden Reiz-/Antwortpfade werden auf eine größere Anzahl von Kontakten an den Feldsteckern verteilt, um Flexibilität zu gewährleisten. Adaptermodule für beliebige Kabelbäume können unter Verwendung des genormten Steckverbinders leicht hergestellt werden.

### Beschreibung der Erfindung

Es ist daher die Aufgabe der Erfindung, eine Lösung bereitzustellen, mittels welcher Kabelbäume besonders einfach geprüft werden können.

Diese Aufgabe wird durch die Gegenstände der unabhängigen Ansprüche gelöst. Weitere mögliche Ausgestaltungen der Erfindung sind insbesondere in den abhängigen Ansprüchen angegeben.

Das erfindungsgemäße modulare Prüfsystem zur automatisierten Prüfung unterschiedlicher Varianten von Kabelbäumen umfasst mehrere Transportvorrichtungen, welche dazu ausgelegt sind, die jeweiligen auf Baubrettern angeordneten Kabelbäume aufzunehmen und zu transportieren. Zudem umfasst das Prüfsystem unterschiedliche an den Transportvorrichtungen anbringbare Varianten von Konturaufnahmen zum Aufnehmen unterschiedlicher Varianten von Steckverbindern der Kabelbäume. Je nach zu prüfender Kabelbaumvariante können also die passenden Varianten von Konturaufnahmen ausgewählt und an den jeweiligen Transportvorrichtungen angebracht werden, um kabelbaumspezifisch die jeweiligen Varianten von Steckverbindern der Kabelbäume aufnehmen zu können. Insbesondere können die Konturaufnahmen so an den Transportvorrichtungen angeordnet werden, dass bei bestimmungsgemäßer Positionierung der jeweiligen Transportvorrichtungen an den jeweiligen Baubrettern die Konturaufnahmen oberhalb von den Baubrettern angeordnet sind. So kann beispielsweise ein Werker die jeweiligen Steckverbinder der Kabelbäume ganz einfach in bzw. an den Konturaufnahmen anbringen, welche an der betreffenden Transportvorrichtung angeordnet sind. Das Baubrett kann anschließend entfernt werden, wobei der Kabelbaum mittels der Transportvorrichtung gehalten und transportiert werden kann.

Des Weiteren umfasst das modulare Prüfsystem wenigstens eine Prüfvorrichtung mit mehreren Prüfanschlüssen zum mittelbaren Anschließen der Prüfvorrichtung an jeweiligen Steckverbinderausgängen der Steckverbinder der Kabelbäume. Mittels der Prüfvorrichtung ist es möglich, unterschiedlichste Prüfungen an den jeweiligen Kabelbäumen vorzunehmen.

So können beispielsweise verschiedenste elektrische Prüfungen vorgenommen werden. Darüber hinaus ist es beispielsweise auch möglich, mittels Luftdruck Prüfungen vorzunehmen. Darüber hinaus kann die Prüfvorrichtung beispielsweise auch verschiedenste Sensoren und/oder Videosysteme aufweisen, um die unterschiedlichen Kabelbäume zu überprüfen.

Des Weiteren umfasst das modulare Prüfsystem unterschiedliche Varianten von Adaptern, auch als Rastertransformatoren zu verstehen, zum Verbinden der Prüfvorrichtung mit den unterschiedlichen Varianten der Steckverbinder der Kabelbäume. Die Adapter weisen jeweils einen variantenspezifischen Eingang zum Herstellen einer Steckverbindung mit den jeweiligen Steckverbinderausgängen der Varianten der Steckverbinder und einen jeweiligen Ausgang zum Herstellen einer Steckverbindung mit den Prüfanschlüssen der Prüfvorrichtung auf. Die als Rastertransformatoren dienenden Adapter haben also die Funktion, unterschiedliche Varianten der Steckverbinder der Kabelbäume mit den jeweiligen Prüfanschlüssen der Prüfvorrichtung zu verbinden. Die unterschiedlichen Varianten der Adapter sind hinsichtlich ihres jeweiligen Eingangs so ausgebildet, dass diese zu jeweiligen Steckverbinderausgängen der jeweiligen Varianten der Steckverbinder passen. Beispielsweise können die variantenspezifischen Eingänge der Adapter eine unterschiedliche Anzahl und Positionierung von Pins oder anderweitigen elektrischen Anschlüssen aufweisen, welche auf das Steckerbild der jeweiligen Steckverbinder angepasst sind. Unter Vermittlung der Adapter ist es also möglich, die Prüfvorrichtung mit den unterschiedlichen Varianten der Steckverbinder der Kabelbäume zu verbinden.

Zudem umfasst das modulare Prüfsystem wenigstens einen Adapterträger, an welchen die unterschiedlichen Varianten der Adapter kabelbaumspezifisch an verschiedenen Positionen des Adapterträgers anbringbar sind. Der Adapterträger kann beispielsweise einen Führungsrahmen bzw. einen Sortierrahmen aufweisen, an welchem die verschiedenen als Rastertransformatoren dienenden Adapter in verschiedenen Positionen abgestimmt auf die jeweils zu prüfenden Kabelbaumvariante angeordnet werden können.

Mittels des modularen Prüfsystems ist es auf einfache Weise möglich, unterschiedliche Varianten von Kabelbäumen automatisiert zu prüfen. Dafür können die besagten Transportvorrichtungen kabelbaumspezifisch konfiguriert bzw. ausgestattet werden, indem die jeweils für die betreffende Kabelbaumvariante passende Anordnung von jeweiligen Varianten von Konturaufnahmen ausgewählt und entsprechend an den Transportvorrichtungen positioniert wird. Jeweilige auf den Baubrettern fertig montierte bzw. hergestellte Kabelbäume können an besagten Transportvorrichtungen bzw. umgekehrt positioniert werden, so dass es möglich ist, mittels der Transportvorrichtungen und den daran angebrachten Konturaufnahmen die jeweiligen Kabelbäume von den Baubrettern aufzunehmen. Mittels der jeweiligen Transportvorrichtung ist es dann möglich, die aufgenommenen Kabelbäume an die wenigstens eine Prüfvorrichtung zu transportieren. Der besagte Adapterträger kann automatisiert mit den passenden Varianten von Adaptern, also mit den passenden Varianten der Rastertransformatoren, ausgestattet und bestückt werden. Der Adapterträger mit seinen Adaptern bzw. Rastertransformatoren wird dann zwischen der Prüfvorrichtung und den jeweiligen Kabelbäumen angeordnet, deren Steckverbinder an den betreffenden Konturaufnahmen der jeweiligen Transportvorrichtungen fixiert sind. Unter Vermittlung der als Rastertransformatoren dienenden Adapter ist es dann möglich, ganz einfach und vor allem automatisiert die jeweiligen Steckverbinder der Kabelbäume mit den jeweiligen Prüfanschlüssen der Prüfvorrichtung zu verbinden. Anschließend kann die Prüfvorrichtung insbesondere automatisiert unterschiedlichste Prüfungen am betreffenden Kabelbaum vornehmen.

Die jeweils zu prüfenden Kabelbäume können nach ihrer Fertigstellung also ganz einfach von den jeweiligen Baubrettern abgenommen werden, indem die betreffenden Steckverbinder der Kabelbäume an den betreffenden Konturaufnahmen der Transportvorrichtungen angeordnet bzw. eingesteckt werden. Ein aufwendiges Handling und Transportieren der Kabelbäume kann dadurch entfallen. Ein Werker muss beispielsweise lediglich die einzelnen Steckverbinder des betreffenden Kabelbaums in die jeweiligen Konturaufnahmen der betreffenden Transportvorrichtung einstecken. Danach kann der betreffende Kabelbaum ganz einfach von dem Baubrett abgenommen und mittels der Transportvorrichtung zur Prüfvorrichtung transportiert werden. Im Zuge des Einsteckens der Steckverbinder in die jeweiligen Konturaufnahmen ist es beispielsweise schon möglich, gehäusespezifische Merkmale der jeweiligen Steckverbinder zu überprüfen.

Die Steckverbinder der Kabelbäume können also während der Abnahme der Kabelbäume von den jeweiligen Baubrettern direkt in die betreffenden Konturaufnahmen gesteckt werden, welche an den Transportvorrichtungen angeordnet sind. Hierbei kann bereits eine Vorprüfung von gehäusespezifischen Merkmalen hinsichtlich der Steckverbinder erfolgen, insbesondere im Hinblick auf ihre Farbe, Kontur, Primärverrastung, Sekundärverrastung, Anbauteile und dergleichen. Die elektrische Prüfung der Kabelbäume erfolgt mittels der besagten wenigstens einen Prüfvorrichtung, wobei diese unabhängig von einer Produktionslinie der Kabelbäume angeordnet sein kann. Eine Anpassung bzw. Adaption an unterschiedliche Varianten von zu prüfenden Kabelbäumen erfolgt insbesondere durch die automatisch auswählbaren und tauschbaren Adapter bzw. Rastertransformatoren. Diese Adapter sind also nicht fest mit den jeweiligen Konturaufnahmen verbunden und diesen auch nicht direkt zugeordnet.

Ein Zusammenlegen der jeweiligen zu überprüfenden Kabelbäume am Baubrett entfällt also. Dafür müssen somit bei der Verwendung des modularen Prüfsystems keine Werker mehr angelernt werden. Der eigentliche Transport der Kabelbäume ist mittels des modularen Prüfsystems unter Zuhilfenahme der jeweiligen Transportvorrichtungen denkbar einfach. Dadurch ergibt sich auch ein besonders ergonomisches Arbeiten, da Werker die mitunter sehr schweren Kabelbäume unter Zuhilfenahme der Transportvorrichtung besonders einfach handhaben können. Beschädigungen an den Kabelbäumen können vermieden werden, da diese ganz einfach mittels der an den Transportvorrichtungen angeordneten Konturaufnahmen von den jeweiligen Baubrettern abgenommen werden können.

Zudem müssen die einzelnen Steckverbinder der zu überprüfenden Kabelbäume nicht mehr manuell an jeweiligen Prüfanschlüssen der Prüfvorrichtung angesteckt werden. Dies kann bei dem modularen Prüfsystem unter Vermittlung der Adapter bzw. Rastertransformatoren automatisch erfolgen. Insbesondere können bei dem modularen Prüfsystem auch Manipulationsmöglichkeiten insbesondere während einer elektrischen Prüfung ausgeschlossen werden. Zudem ergibt sich der Vorteil, dass nachdem die jeweiligen Varianten der Kabelbäume mittels der Prüfvorrichtung überprüft worden sind, sich die Kabelbäume immer noch an den Transportvorrichtungen mit den jeweiligen Konturaufnahmen befinden. Somit befinden sich die jeweiligen Kabelbäume nach ihrer Überprüfung in einer definierten Struktur bzw. Anordnung, so dass diese besonders einfach verpackt werden können.

Insbesondere ist es mittels des modularen Prüfsystems möglich, einen sehr hohen Standardisierungsgrad hinsichtlich einer elektrischen Prüfung zu erzielen. Die wenigstens eine Prüfvorrichtung kann insbesondere immer gleich, also standardisiert, aufgebaut sein.

Die Anpassbarkeit an unterschiedliche zu überprüfende Varianten von Kabelbäumen ergibt sich insbesondere durch das Vorsehen der unterschiedlichen Varianten von Adaptern bzw. Rastertransformatoren. Diese können variantenspezifisch bzw. kabelbaumspezifisch an der entsprechenden Position der jeweiligen Adapterträger, welche beispielsweise Sortierrahmen oder dergleichen aufweisen können, angeordnet werden. So ist es möglich, unterschiedliche Varianten bzw. Derivate von Kabelbäumen mittels des modularen Prüfsystems zu überprüfen, wobei die üblicherweise teure Prüfvorrichtung einen standardisierten Aufbau aufweisen kann, es also nur eine einzige Variante der Prüfvorrichtung geben muss.

Eine mögliche Ausgestaltung der Erfindung sieht vor, dass die Transportvorrichtung wenigstens eine Montageplatte aufweist, an der die Konturaufnahmen fixierbar sind, wobei die Montageplatte in einer bestimmungsgemäßen Aufnahmeposition der Transportvorrichtung zum Bestücken der Konturaufnahmen mit den jeweiligen Steckverbindern der Kabelbäume oberhalb von den Baubrettern angeordnet ist. Ein mit einem der Kabelbäume bestücktes Baubrett muss also einfach nur unterhalb von der Montageplatte der betreffenden Transportvorrichtung angeordnet werden. Die Montageplatte ist dabei so hoch angeordnet, dass diese oberhalb von den Kabelbäumen angeordnet ist, solange sie auf den Baubrettern angeordnet sind. Es kann beispielsweise ein Werker ganz bequem die einzelnen Steckverbinder des betreffenden Kabelbaums in den jeweiligen Konturaufnahmen positionieren. Zudem ist es auch möglich, dass die Transportvorrichtungen noch Halterungen zum Halten jeweiliger Kabel der Kabelbäume aufweisen. Mittels der Transportvorrichtung ist es also ganz einfach möglich, die jeweils zu prüfenden Kabelbäume von den Baubrettern abzunehmen. Zudem ist es auch möglich, eine kabelbaumspezifische automatisierte Bestückung der besagten Montageplatten der Transportvorrichtung mit den passenden Konturaufnahmen zu realisieren. Falls sich die zu prüfenden Kabelbäume zum Beispiel hinsichtlich der Anordnung ihrer jeweiligen Steckverbinder und der unterschiedlichen Varianten der eingesetzten Steckverbinder unterscheiden, so ist es möglich, besagte Montageplatte mit den passenden Varianten der jeweiligen Konturaufnahmen automatisiert zu bestücken. So können die Transportvorrichtungen ganz einfach automatisiert an die unterschiedlichen zu prüfenden Varianten der Kabelbäume angepasst werden.

Eine weitere mögliche Ausgestaltung der Erfindung sieht vor, dass bei bestimmungsgemäßer Anordnung der Konturaufnahmen an der Transportvorrichtung die Steckverbinder der Kabelbäume seitlich in die Konturaufnahmen einsteckbar und verriegelbar sind. So können die Steckverbinder ganz einfach beispielsweise von einem Werker bei entsprechend passender Anordnung in der betreffenden Transportvorrichtung an einem der Baubretter seitlich in die betreffenden Konturaufnahmen eingesteckt und darin verriegelt werden. Dafür weisen die Konturaufnahmen entsprechende seitlich zugängliche Aussparungen auf, welche angepasst an die unterschiedlichen Varianten der Steckverbinder der Kabelbäume sind. So können die Steckverbinder ganz einfach seitlich in die jeweiligen Konturaufnahmen eingeführt und darin bzw. daran verriegelt werden.

Gemäß einer weiteren möglichen Ausgestaltung der Erfindung ist es vorgesehen, dass bei bestimmungsgemäß in den Konturaufnahmen aufgenommenen Steckverbindern die jeweiligen Steckverbinderausgänge nach oben weisen. So ist es ganz einfach möglich, die mit den jeweiligen Kabelbäumen bestückten Transportvorrichtungen unterhalb von der Prüfvorrichtung anzuordnen, wobei die Steckverbinderausgänge der jeweiligen Steckverbinder nach oben weisen und dadurch besonders einfach unter Vermittlung der Adapter bzw. Rastertransformatoren mit den Prüfanschlüssen der Prüfvorrichtung verbunden werden können.

In einer weiteren möglichen Ausgestaltung der Erfindung ist es vorgesehen, dass die Prüfanschlüsse unterseitig an der Prüfvorrichtung angeordnet sind, wobei die Transportvorrichtungen unterhalb von der Prüfvorrichtung positionierbar sind, so dass unter Vermittlung des in Hochrichtung dazwischen positionierbaren und mit den Adaptern bestückten Adapterträgers die Steckverbinderausgänge mit den Prüfanschlüssen verbindbar sind. Wurde eine der mit den Kabelbäumen bestückten Transportvorrichtungen also unterhalb von der Prüfvorrichtung angeordnet, so ist es beispielsweise möglich, dass die Prüfvorrichtung mitsamt dem Adapterträger in Hochrichtung nach unten bewegt wird, in Folge dessen eine Verbindung zwischen der Prüfvorrichtung und den jeweiligen Steckverbinderausgängen der Steckverbinder des betreffenden Kabelbaums hergestellt wird. Die Prüfvorrichtung kann beispielsweise mit einem Hubmechanismus ausgestattet sein oder einen anderweitigen Antrieb aufweisen, der automatisiert betätigt werden kann, um die Prüfvorrichtung in vertikaler Richtung zu verfahren und so unter Vermittlung der Adapter mit den jeweiligen Steckverbindern der zu überprüfenden Kabelbäume zu verbinden, welche mittels der jeweiligen Transportvorrichtung aufgenommen und unterhalb von der Prüfvorrichtung anordenbar sind.

Eine weitere mögliche Ausgestaltung der Erfindung sieht vor, dass der Adapterträger Aufnahmebereiche zum Aufnehmen der Adapter in einer jeweiligen Prüfposition sowie wenigstens einen Speicherbereich für momentan nicht benötigte Adapter aufweist. Der Adapterträger kann also beispielsweise Aussparungen oder dergleichen aufweisen, welche als Aufnahmebereiche zum Aufnehmen der jeweiligen Adapter dienen. So können je nach zu überprüfender Kabelbaumvariante die passenden Adapter aus dem Speicherbereich entnommen und entsprechend am Adapterträger positioniert werden. Der Adapterträger kann dafür einen Führungsrahmen bzw. einen Sortierrahmen mit entsprechenden Aussparungen aufweisen, in denen die jeweiligen Adapter angeordnet werden können. Die austauschbaren Adapter bzw. Rastertransformatoren können also automatisch beispielsweise in besagten Führungsrahmen bzw. Sortierrahmen angeordnet werden. So kann die Prüfung der jeweiligen Kabelbäume variantenspezifisch konfiguriert werden.

Eine weitere mögliche Ausgestaltung der Erfindung sieht vor, dass das modulare Prüfsystem dazu ausgelegt ist, passend für eine jeweilige Variante des zu prüfenden Kabelbaums die benötigten Adapter automatisch auszuwählen und an den entsprechenden Aufnahmebereichen zu positionieren. Beispielsweise kann das modulare Prüfsystem einen Roboter aufweisen, welcher dazu ausgelegt ist, passend für die jeweilige Variante des zu prüfenden Kabelbaums die benötigten Adapter automatisch auszuwählen, aus dem besagten Speicherbereich zu entnehmen und an den entsprechenden Aufnahmebereichen zu positionieren. Zuvor in den Aufnahmebereichen angeordnete und nicht mehr benötigte Varianten der Adapter können wiederum automatisch im besagten Speicherbereich positioniert werden, in dem sie eine Art Parkposition einnehmen. Die variantenspezifische Konfiguration der Adapterträger mit den passenden Adaptern kann also automatisch und somit besonders einfach und fehlerfrei erfolgen.

Gemäß einer weiteren möglichen Ausgestaltung der Erfindung ist es vorgesehen, dass die Prüfanschlüsse der Prüfvorrichtung jeweils mehrere elektrische Anschlüsse zum Überprüfen der Kabelbäume aufweisen. Die Prüfanschlüsse können beispielsweise mehrere elektrische Kontakte in Form von Pins, Buchsen oder dergleichen aufweisen. Mittels der elektrischen Prüfanschlüsse ist es also möglich, verschiedenste elektrische Prüfungen an den Kabelbäumen vorzunehmen.

Gemäß einer weiteren möglichen Ausgestaltung der Erfindung ist es vorgesehen, dass die Prüfanschlüsse der Prüfvorrichtung jeweils wenigstens einen pneumatischen Anschluss zum Überprüfen der Steckverbinder der Kabelbäume aufweisen. Mit Hilfe des jeweiligen pneumatischen Anschlusses ist es beispielsweise möglich, Verriegelungen an den Steckverbindern zu testen und/oder auch die Steckverbinder beispielsweise auf Dichtheit zu überprüfen.

Eine weitere mögliche Ausgestaltung der Erfindung sieht vor, dass die Prüfanschlüsse der Prüfvorrichtung alle den gleichen Standardaufbau aufweisen, wobei alle Ausgänge der unterschiedlichen Varianten der Adapter ebenfalls einen entsprechenden Standardaufbau aufweisen. Mit anderen Worten ist es also möglich, dass sämtliche Prüfanschlüsse der Prüfvorrichtung zum Beispiel hinsichtlich ihres Steckerbilds, also bezüglich der Anordnung ihrer jeweiligen elektrischen Anschlüsse, und/oder hinsichtlich ihrer Anordnung ihres jeweiligen pneumatischen Anschlusses immer gleich aufgebaut sind. Die dazu passenden Ausgänge der unterschiedlichen Varianten der Adapter können dadurch auch immer gleich aufgebaut sein. Dadurch ergibt sich eine besonders geringe Varianz bzw. Variantenvielfalt an den Prüfanschlüssen der Prüfvorrichtung und bezüglich der Ausgänge der unterschiedlichen Variante der Adapter bzw. Rastertransformatoren.

Gemäß einer weiteren möglichen Ausgestaltung der Erfindung ist es vorgesehen, dass die Eingänge der unterschiedlichen Varianten der Adapter sich durch die Anzahl und/oder Anordnung von mit den Steckverbinderausgängen koppelbaren elektrischen und/oder pneumatischen Schnittstellen voneinander unterscheiden. Die Eingänge der unterschiedlichen Varianten der Adapter bzw. Rastertransformatoren sind also an die jeweiligen Varianten der Steckverbinder und ihre jeweilige Gestaltung ihrer Steckverbinderausgänge angepasst. Für jede Variante von Steckverbindern der Kabelbäume gibt es also eine passende Variante eines Adapters. Unter Vermittlung der Adapter ist es so ganz einfach möglich, die standardisierte Prüfvorrichtung mit den jeweiligen Steckverbindern der unterschiedlichen Varianten von Kabelbäumen zu verbinden.

Eine weitere mögliche Ausgestaltung der Erfindung sieht vor, dass das modulare Prüfsystem dazu ausgelegt ist, die Prüfvorrichtung automatisch unter Vermittlung des Adapterträgers mit den Steckverbindern des jeweiligen mittels einem der Transportvorrichtungen aufgenommenen Kabelbaums zu koppeln. Insbesondere ist es möglich, dass das modulare Prüfsystem die Prüfvorrichtung passend zum betreffenden Adapterträger positioniert und so die Prüfvorrichtung mit den jeweiligen Adaptern automatisiert verbindet. Danach ist es auch möglich, die Adapter automatisiert mit den jeweiligen Steckverbindern des betreffenden Kabelbaums zu koppeln. So ist es ohne manuelles Zutun möglich, die Prüfvorrichtung unter Vermittlung der Adapter bzw. Rastertransformatoren automatisch mit den jeweiligen Steckverbindern des betreffenden Kabelbaums zu koppeln bzw. zu verbinden, wonach ein automatisierter Prüfzyklus durchgeführt werden kann, mit welchem beispielsweise der betreffende Kabelbaum elektrisch überprüft wird. Zudem kann das modulare Prüfsystem dazu ausgelegt sein, die Prüfvorrichtung nach dem Abschluss des Prüfvorgangs automatisch wieder von den Steckverbindern des betreffenden Kabelbaums zu trennen.

Eine weitere mögliche Ausgestaltung der Erfindung sieht vor, dass das modulare Prüfsystem dazu ausgelegt ist, im unter Vermittlung des Adapterträgers mit den Steckverbindern gekoppelten Zustand automatisch eine vorgebbare Prüfroutine beim entsprechenden Kabelbaum durchzuführen. Die Prüfroutinen können sich dabei auch je nach zu prüfender Variante des betreffenden Kabelbaums unterscheiden. Das modulare Prüfsystem ist insbesondere dazu ausgelegt, zu erkennen, was für eine Variante von Kabelbäumen gerade mit der Prüfvorrichtung verbunden wurde, um dann beispielsweise den passenden Prüfzyklus auszuwählen und diesen automatisch durchzuführen.

Bei dem erfindungsgemäßen Verfahren zur automatisierten Prüfung unterschiedlicher Varianten von Kabelbäumen werden die jeweiligen Kabelbäume mittels des erfindungsgemäßen modularen Prüfsystems oder einer möglichen Ausgestaltung des erfindungsgemäßen modularen Prüfsystems von jeweiligen Baubrettern aufgenommen, transportiert und überprüft. Mögliche Ausgestaltungen des modularen Prüfsystems sind als mögliche Ausgestaltungen des erfindungsgemäßen Verfahrens und umgekehrt anzusehen, wobei das modulare Prüfsystem insbesondere Mittel zur Durchführung der Verfahrensschritte aufweist.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine schematische Draufsicht auf mehrere H-förmige Baubretter, welche zur Montage bzw. Herstellung von Kabelbäumen genutzt werden, wobei zudem ein modulares Prüfsystem zur automatisierten Prüfung unterschiedlicher Varianten von Kabelbäumen dargestellt ist;
- Fig. 2: eine schematische Seitenansicht des modularen Prüfsystems zur automatisierten Prüfung unterschiedlicher Varianten von Kabelbäumen.

In den Figuren sind gleiche oder funktionsgleiche Elemente mit den gleichen Bezugszeichen versehen worden.

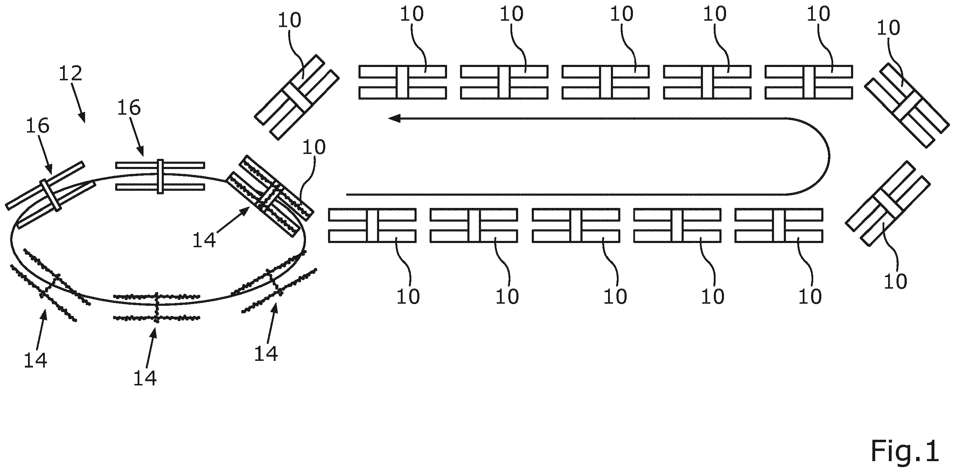

Mehrere Baubretter 10 sind in einer schematischen Darstellung in Fig. 1 gezeigt. Die H-förmigen Baubretter 10 dienen zur Aufnahme und Montage von unterschiedlichen Varianten von hier nicht näher dargestellten Kabelbäumen. Links von den Baubrettern 10 ist schematisch ein modulares Prüfsystem 12 zur automatisierten Prüfung unterschiedlicher Varianten von Kabelbäumen dargestellt. Das modulare Prüfsystem 12 umfasst mehrere vorliegend im wesentlichen ebenfalls H-förmige Transportvorrichtungen 14, welche dazu ausgelegt sind, die jeweiligen auf den Baubrettern 10 angelieferten bzw. angeordneten Kabelbäume aufzunehmen und zu transportieren.

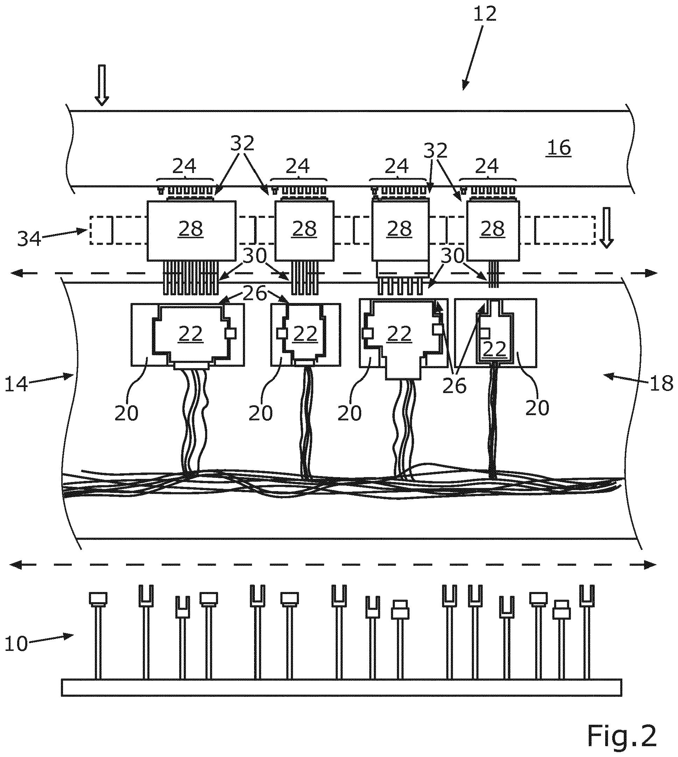

Der konkrete Aufbau der Transportvorrichtung 14 wird später noch anhand von Fig. 2 genauer erläutert. Des Weiteren umfasst das modulare Prüfsystem 12 im vorliegend gezeigten Fall noch zwei Prüfvorrichtungen 16, an welchen die mittels der Transportvorrichtung 14 aufgenommenen Kabelbäume überprüft werden können. Mittels der Transportvorrichtung 14 ist es also möglich, verschiedene Varianten von Kabelbäumen, welche auf den Baubrettern 10 hergestellt bzw. montiert worden sind, aufzunehmen und zu den jeweiligen Prüfvorrichtungen 16 zu transportieren.

In Fig. 2 ist eine mögliche Ausgestaltung des modularen Prüfsystems 12 in einer schematischen Seitenansicht gezeigt. Vorliegend ist die Situation dargestellt, dass eine der Transportvorrichtungen 14 unterhalb von einer der Prüfvorrichtungen 16 angeordnet wurde. Die jeweiligen Transportvorrichtungen 14 umfassen eine oder mehrere hier nicht näher dargestellte Montageplatten, welche passend zur Form der Baubretter 10 bzw. zur Form der jeweils zu überprüfenden Kabelbäume ebenfalls H-förmig angeordnet sein können. Wie bereits erwähnt, sind die jeweiligen Transportvorrichtungen 14 dazu ausgelegt, die jeweiligen auf den Baubrettern 10 angeordneten Kabelbäume 18 aufzunehmen und zu transportieren.

Das modulare Prüfsystem 12 umfasst unterschiedliche an den jeweiligen Transportvorrichtungen 14 anbringbare Varianten von Konturaufnahmen 20 zum Aufnehmen unterschiedlicher Varianten von Steckverbindern 22 der jeweiligen Varianten von zu überprüfenden Kabelbäumen 18. Die Konturaufnahmen 20 sind so gestaltet, dass in diese die jeweils unterschiedlichen Varianten der Steckverbinder 22 seitlich eingeführt und darin fixiert werden können.

Die Prüfvorrichtungen 16 weisen jeweils mehrere Prüfanschlüsse 24 zum mittelbaren Anschließen der jeweiligen Prüfvorrichtungen 16 an jeweiligen Steckverbinderausgängen 26 der Steckverbinder 22 auf. Des Weiteren umfasst das modulare Prüfsystem 12 unterschiedliche Varianten von Adaptern 28 zum Verbinden der jeweiligen Prüfvorrichtung 16 mit den unterschiedlichen Varianten der Steckverbinder 22 der jeweiligen Kabelbäume 18. Die Adapter 28 bzw. Rastertransformatoren weisen jeweils einen variantenspezifischen Eingang 30 zum Herstellen einer Steckverbindung mit den jeweiligen Steckverbinderausgängen 26 der Varianten der Steckverbinder 22 auf. Zudem umfassen die Adapter 28 einen jeweiligen Ausgang 32 zum Herstellen einer Steckverbindung mit den jeweiligen Prüfanschlüssen 24 in der betreffenden Prüfvorrichtung 16.

Die hier nicht näher dargestellte Montageplatte bzw. Montageplatten an den Transportvorrichtungen 14 ist in der hier gezeigten bestimmungsgemäßen Aufnahmeposition der Transportvorrichtung 14 zum Bestücken der jeweiligen Konturaufnahmen 20 mit den jeweiligen Steckverbindern 22 oberhalb von den Baubrettern 10 angeordnet. Mit anderen Worten können die Konturaufnahmen 20 also so an den jeweiligen Transportvorrichtungen 14 angeordnet und fixiert werden, dass diese in Hochrichtung oberhalb von den Baubrettern 10 und den entsprechenden von den Baubrettern 10 aufzunehmenden Kabelbäumen 18 angeordnet sind.

So kann beispielsweise ein Werker bei entsprechender Positionierung der betreffenden Transportvorrichtungen 14 oberhalb vom jeweiligen Baubrett 10 die betreffenden Steckverbinder 22 ergreifen und seitlich in die Konturaufnahmen 20 einführen und darin verriegeln. Die Transportvorrichtungen 14 können hier nicht näher dargestellte Halterungen aufweisen, welche dazu dienen können, hier nicht näher bezeichnete Kabel bzw. Kabelbündel der jeweiligen Kabelbäume 18 zusätzlich noch zu halten bzw. zu fixieren. Nachdem die jeweiligen Steckverbinder 22 in die Konturaufnahmen 20 eingesteckt worden sind, kann das betreffende Baubrett 10 entfernt werden, da die jeweilige Variante des Kabelbaums 18 mittels der Transportvorrichtungen 14 gehalten wird.

Wie zu erkennen, weisen bei bestimmungsgemäßer Aufnahme der Steckverbinder 22 in den jeweiligen Konturaufnahmen 20 die Steckverbinderausgänge 26 nach oben und sind so den jeweiligen Eingängen 30 der als Rastertransformatoren dienenden Adapter 28 zugewandt. Wie zu erkennen, sind die jeweiligen Prüfanschlüsse 24 in den Prüfvorrichtungen 16 unterseitig an den jeweiligen Prüfvorrichtungen 16 angeordnet. Die Transportvorrichtungen 14 können unterhalb von den jeweiligen Prüfvorrichtungen 16 positioniert werden, so dass unter Vermittlung eines in Hochrichtung dazwischen positionierbaren Adapterträgers 34, an dem die jeweiligen Adapter 28 angebracht sind, die Steckverbinderausgänge 26 mit den Prüfanschlüssen 24 der Prüfvorrichtung 16 verbindbar sind.

Der Adapterträger 34 kann eine Art Führungsrahmen bzw. Sortierrahmen aufweisen, an welchem die unterschiedlichen Varianten der als Rastertransformatoren dienenden Adapter 28 je nach zu prüfender Variante des Kabelbaums 18 passgenau ausgewählt und angeordnet werden können. Der Adapterträger 34 weist mit anderen Worten also hier nicht näher gekennzeichnete Aufnahmebereiche zum Aufnehmen der verschiedenen Varianten der Adapter 28 in einer jeweiligen Prüfposition auf. Darüber hinaus kann der Adapterträger 34 einen hier nicht näher dargestellten Speicherbereich für momentan nicht benötigte Adapter 28 aufweisen.

Je nachdem, was für eine Variante der Kabelbäume 18 zu überprüfen ist, können die Adapter 28 automatisiert ausgewählt und am Adapterträger 34 in ihrer jeweils passenden Prüfposition angeordnet werden, so dass die jeweiligen Eingänge 30 der Adapter 28 auch zu den jeweiligen Steckverbinderausgängen 26 passen. Beispielsweise kann das modulare Prüfsystem 12 einen Roboter aufweisen, der dazu ausgelegt ist, passend für die jeweils zu überprüfende Variante des Kabelbaums 18 die passenden Varianten der jeweiligen Adapter 28 auszuwählen und an entsprechender Stelle des Adapterträgers 34 zu positionieren, bevor unter Vermittlung des Adapterträgers 34 bzw. der ausgewählten Adapter 28 eine Verbindung zwischen der betreffenden Prüfvorrichtung 16 und den Steckverbindern 22 hergestellt wird.

Die Prüfanschlüsse 24 der Prüfvorrichtung 16 umfassen mehrere hier nicht näher bezeichnete elektrische Anschlüsse zum Überprüfen der jeweiligen Kabelbäume 18 und jeweils wenigstens einen pneumatischen Anschluss zum Überprüfen der Steckverbinder 22 der jeweiligen Kabelbäume 18. Die Prüfanschlüsse 24 der Prüfvorrichtung 16 können alle den gleichen Standardaufbau aufweisen, wobei alle Ausgänge 32 der unterschiedlichen Varianten der Adapter 28 ebenfalls einen dazu passenden Standardaufbau aufweisen können. Ein jeweiliges Steckerbild der Prüfanschlüsse 24 hinsichtlich ihrer elektrischen Anschlüsse und pneumatischen Anschlüsse ist also immer gleich aufgebaut, entsprechend auch ein entsprechendes Steckerbild der jeweiligen Ausgänge 32 der unterschiedlichen Varianten der Adapter 28. Die Adapter 28 unterscheiden sich also nur dadurch, dass sie ein unterschiedliches Steckerbild an ihren Eingängen 30 aufweisen, welche auf die unterschiedlichen Varianten der Steckverbinder 22 und ihre jeweiligen Steckverbinderausgänge 26 angepasst ist. Die Eingänge 30 der unterschiedlichen Varianten der Adapter 28 unterscheiden sich beispielsweise durch die Anzahl und/oder Anordnung von mit den Steckverbinderausgängen 26 koppelbaren elektrischen und/oder pneumatischen Schnittstellen voneinander.

Das modulare Prüfsystem 12 ist dazu ausgelegt, die jeweilige Prüfvorrichtung 16 automatisch unter Vermittlung des Adapterträgers 34 mit den Steckverbindern 22 des jeweiligen mittels einem der Transportvorrichtung 14 aufgenommenen Kabelbaums 18 zu koppeln. Nachdem die entsprechende Transportvorrichtung 14 mit aufgenommenem Kabelbaum 18 unterhalb von der betreffenden Prüfvorrichtung 16 positioniert worden ist, kann dies beispielsweise mittels Sensoren des modularen Prüfsystems 12 erfasst werden. Sobald ermittelt wird, dass der zu prüfende Kabelbaum 18 passgenau unterhalb von der betreffenden Prüfvorrichtung 16 positioniert wurde, kann der passend zur prüfenden Variante des Kabelbaums 18 mit den entsprechenden Varianten an Adaptern 28 bestückte Adapterträger 34 mit der Prüfvorrichtung 16 verbunden werden. Anschließend kann die Prüfvorrichtung 16 mitsamt dem Adapterträger 34 beispielsweise in vertikaler Richtung nach unten verfahren werden, bis eine automatische Verbindung mit den jeweiligen Steckverbindern 22 des zu überprüfenden Kabelbaums 18 hergestellt wurde.

Das modulare Prüfsystem 12 kann dann im unter Vermittlung des Adapterträgers 34 mit den jeweiligen Steckverbindern 22 gekoppelten Zustand automatisch eine vorgebbare Prüfroutine beim entsprechenden Kabelbaum 18 durchführen. Nachdem der Prüfvorgang bzw. die Prüfroutine abgeschlossen wurde, kann die Prüfvorrichtung 16 mitsamt dem Adapterträger 34 automatisiert in vertikaler Richtung nach oben verfahren werden, so dass die Verbindung zu den Steckverbindern 22 getrennt wird. Danach kann die betreffende Transportvorrichtung 14 mitsamt dem überprüften Kabelbaum 18 weiter transportiert werden. Danach können am Kabelbaum 18 beispielsweise an anderer Stelle weitere Überprüfungen vorgenommen werden und schließlich kann der betreffende Kabelbaum 18 an einer entsprechenden Station von der Transportvorrichtung 14 getrennt und verpackt werden.

Mittels des modularen Prüfsystems 12 ist es also möglich, eine automatisierte Überprüfung von unterschiedlichsten Varianten von Kabelbäumen 18 vorzunehmen. Die Anpassung an unterschiedliche Varianten von zu überprüfenden Kabelbäumen 18 erfolgt insbesondere durch die passende Auswahl und Anordnung der als Rastertransformatoren dienenden Adapter 28, welche an einem Führungsrahmen bzw. Sortierrahmen des Adapterträgers 34 passgenau angeordnet werden können. Die Prüfvorrichtungen 16 können einen standardisierten Aufbau aufweisen und müssen nicht an unterschiedliche Kabelbaumvarianten angepasst werden.

Darüber hinaus ist es auch möglich, die Konturaufnahmen 20 insbesondere automatisch passend zur jeweiligen Variante des zu überprüfenden Kabelbaums 18 auszuwählen und beispielsweise an besagten Montageplatten der Transportvorrichtung 14 so anzuordnen, dass problemlos eine Kopplung der mittels der Konturaufnahmen 20 aufgenommenen Steckverbinder 22 unter Vermittlung der Adapter 28 mit der Prüfvorrichtung 16 ermöglicht wird. Bei dem modularen Prüfsystem 12 ergibt sich eine besonders einfache Handhabung der zu überprüfenden Kabelbäume 18, da diese einfach nur an den jeweiligen Transportvorrichtungen 14, insbesondere an den Konturaufnahmen 20, angebracht werden müssen. Dadurch können die montierten Kabelbäume 18 ganz einfach von den Baubrettern 10 abgenommen und zu den jeweiligen Prüfvorrichtungen 16 transportiert werden. Die verwendeten Prüfvorrichtungen 16 selbst können einen sehr hohen Standardisierungsgrad aufweisen, da die Varianz sich zumindest im Wesentlichen nur im Bereich der Adapter 28 und der Konturaufnahmen 20 abspielt. So ist es möglich, verschiedenste Varianten von Kabelbäumen 18 einer automatischen Prüfung zu unterziehen.

### BEZUGSZEICHENLISTE

- 10: Baubretter
- 12: modulares Prüfsystem
- 14: Transportvorrichtungen
- 16: Prüfvorrichtungen
- 18: Kabelbäume
- 20: Konturaufnahmen
- 22: Steckverbinder der Kabelbäume
- 24: Prüfanschlüsse der Prüfvorrichtungen
- 26: Steckverbinderausgänge der Steckverbinder
- 28: Adapter
- 30: Eingänge der Adapter
- 32: Ausgänge der Adapter
- 34: Adapterträger

## Patentansprüche

1. Modulares Prüfsystem (12) zur automatisieren Prüfung unterschiedlicher Varianten von Kabelbäumen (18), umfassend
- mehrere Transportvorrichtungen (14), welche dazu ausgelegt sind, die jeweiligen auf Baubrettern (10) angeordneten Kabelbäume (18) aufzunehmen und zu transportieren;
- unterschiedliche an den Transportvorrichtungen (14) anbringbare Varianten von Konturaufnahmen (20) zum Aufnehmen unterschiedlicher Varianten von Steckverbindern (22) der Kabelbäume (18);
- wenigstens eine Prüfvorrichtung (16) mit mehreren Prüfanschlüssen (24) zum mittelbaren Anschließen der Prüfvorrichtung (16) an jeweiligen Steckverbinderausgängen (26) der Steckverbinder (22) der Kabelbäume (18);
- unterschiedliche Varianten von Adaptern (28) zum Verbinden der Prüfvorrichtung (16) mit den unterschiedlichen Varianten der Steckverbinder (22) der Kabelbäume (18), aufweisend einen jeweils variantenspezifischen Eingang (30) zum Herstellen einer Steckverbindung mit den jeweiligen Steckverbinderausgängen (26) der Varianten der Steckverbinder (22) und mit einem jeweiligen Ausgang (32) zum Herstellen einer Steckverbindung mit den Prüfanschlüssen (24) der Prüfvorrichtung (16);
- wenigstens einen Adapterträger (34), an welchem die unterschiedlichen Varianten der Adapter (28) kabelbaumspezifisch an verschiedenen Positionen des Adapterträgers (34) anbringbar sind.

2. Modulares Prüfsystem (12) nach Anspruch 1,
**dadurch gekennzeichnet, dass**
die Transportvorrichtung (14) wenigstens eine Montageplatte aufweist, an der die Konturaufnahmen (20) fixierbar sind, wobei die Montageplatte in einer bestimmungsgemäßen Aufnahmeposition der Transportvorrichtung (14) zum Bestücken der Konturaufnahmen (20) mit den jeweiligen Steckverbindern (22) der Kabelbäume (18) oberhalb von den Baubrettern (10) angeordnet ist.

3. Modulares Prüfsystem (12) nach Anspruch 1 oder 2,
**dadurch gekennzeichnet, dass**
bei bestimmungsgemäßer Anordnung der Konturaufnahmen (20) an der Transportvorrichtung (14) die Steckverbinder (22) der Kabelbäume (18) seitlich in die Konturaufnahmen (20) einsteckbar und verriegelbar sind.

4. Modulares Prüfsystem (12) nach einem der vorhergehenden Ansprüche,
**dadurch gekennzeichnet, dass**
bei bestimmungsgemäß in den Konturaufnahmen (20) aufgenommenen Steckverbindern (22) die jeweiligen Steckverbinderausgänge (26) nach oben weisen.

5. Modulares Prüfsystem (12) nach einem der vorhergehenden Ansprüche,
**dadurch gekennzeichnet, dass**
die Prüfanschlüsse (24) unterseitig an der Prüfvorrichtung (16) angeordnet sind, wobei die Transportvorrichtungen (14) unterhalb von der Prüfvorrichtung (16) positionierbar sind, sodass unter Vermittlung des in Hochrichtung dazwischen positionierbaren und mit den Adaptern (28) bestückten Adapterträgers (34) die Steckverbinderausgänge (26) mit den Prüfanschlüssen (24) verbindbar sind.

6. Modulares Prüfsystem (12) nach einem der vorhergehenden Ansprüche,
**dadurch gekennzeichnet, dass**
der Adapterträger (34) Aufnahmebereiche zum Aufnehmen der Adapter (28) in einer jeweiligen Prüfposition sowie wenigstens einen Speicherbereich für momentan nicht benötigte Adapter (28) aufweist.

7. Modulares Prüfsystem (12) nach Anspruch 6,
**dadurch gekennzeichnet, dass**
das modulare Prüfsystem (12) dazu ausgelegt ist, passend für eine jeweilige Variante des zu prüfenden Kabelbaums (18) die benötigen Adapter (28) automatisch auszuwählen und an den entsprechenden Aufnahmebereichen zu positionieren.

8. Modulares Prüfsystem (12) nach einem der vorhergehenden Ansprüche,
**dadurch gekennzeichnet, dass**
die Transportvorrichtungen (14) Halterungen zum Halten jeweiliger Kabel der Kabelbäume (18) aufweisen.

9. Modulares Prüfsystem (12) nach einem der vorhergehenden Ansprüche,
**dadurch gekennzeichnet, dass**
die Prüfanschlüsse (24) der Prüfvorrichtung (16) jeweils mehrere elektrische Anschlüsse zum Überprüfen der Kabelbäume (18) aufweisen.

10. Modulares Prüfsystem (12) nach einem der vorhergehenden Ansprüche,
**dadurch gekennzeichnet, dass**
die Prüfanschlüsse (24) der Prüfvorrichtung (16) jeweils wenigstens einen pneumatischen Anschluss zum Überprüfen der Steckverbinder (22) der Kabelbäume (18) aufweisen.

11. Modulares Prüfsystem (12) nach einem der vorhergehenden Ansprüche,
**dadurch gekennzeichnet, dass**
die Prüfanschlüsse (24) der Prüfvorrichtung (16) alle den gleichen Standardaufbau ausweisen, wobei alle Ausgänge (32) der unterschiedlichen Varianten der Adapter (28) ebenfalls einen entsprechenden Standardaufbau aufweisen.

12. Modulares Prüfsystem (12) nach einem der vorhergehenden Ansprüche,
**dadurch gekennzeichnet, dass**
die Eingänge (30) der unterschiedlichen Varianten der Adapter (28) sich durch die Anzahl und/oder Anordnung von mit den Steckverbinderausgängen (26) koppelbaren elektrischen und/oder pneumatischen Schnittstellen voneinander unterscheiden.

13. Modulares Prüfsystem (12) nach einem der vorhergehenden Ansprüche,
**dadurch gekennzeichnet, dass**
das modulare Prüfsystem (12) dazu ausgelegt ist, die Prüfvorrichtung (16) automatisch unter Vermittlung des Adapterträgers (34) mit den Steckverbindern (22) des jeweiligen mittels einem der Transportvorrichtungen (14) aufgenommenen Kabelbaums (18) zu koppeln.

14. Modulares Prüfsystem (12) nach einem der vorhergehenden Ansprüche,
**dadurch gekennzeichnet, dass**
das modulare Prüfsystem (12) dazu ausgelegt ist, im unter Vermittlung des Adapterträgers (34) mit den Steckverbindern (22) gekoppelten Zustand automatisch eine vorgebbare Prüfroutine beim entsprechenden Kabelbaum (18) durchzuführen.

15. Verfahren zur automatisieren Prüfung unterschiedlicher Varianten von Kabelbäumen (18), bei welchem mittels eines modularen Prüfsystems (12) nach einem der vorhergehenden Ansprüche die jeweiligen Kabelbäume (18) von jeweiligen Baubrettern (10) aufgenommen, transportiert und überprüft werden.

## Claims

1. Modular testing system (12) for the automated testing of different variants of cable harnesses (18), comprising
- a plurality of transport devices (14) which are configured to pick up and transport the respective cable harnesses (18) arranged on building boards (10) ;
- different variants of contour holders (20) being attachable to the transport devices (14) for picking up different variants of connectors (22) of the cable harnesses (18);
- at least one testing device (16) having a plurality of test terminals (24) for the indirect connection of the testing device (16) to respective connector outputs (26) of the connectors (22) of the cable harnesses (18);
- different variants of adapters (28) for connecting the testing device (16) to the different variants of the connectors (22) of the cable harnesses (18), having a respectively variant-specific input (30) for producing a plug connection to the respective connector outputs (26) of the variants of the connectors (22), and having a respective output (32) for producing a plug connection to the test terminals (24) of the testing device (16);
- at least one adapter carrier (34) to which the different variants of the adapters (28) are attachable at various positions of the adapter carrier (34) in a manner specific to the cable harness.

2. Modular testing system (12) according to Claim 1, **characterized in that**
the transport device (14) has at least one mounting plate, to which the contour holders (20) are fixable, wherein the mounting plate is arranged in an intended holding position of the transport device (14) for populating the contour holders (20) with the respective connectors (22) of the cable harnesses (18) above the building boards (10).

3. Modular testing system (12) according to Claim 1 or 2,
**characterized in that**,
when the contour holders (20) are arranged as intended on the transport device (14), the connectors (22) of the cable harnesses (18) are insertable and lockable laterally into the contour holders (20).

4. Modular testing system (12) according to one of the preceding claims,
**characterized in that**,
when the connectors (22) are held in the contour holders (20) as intended, the respective connector outputs (26) point upwards.

5. Modular testing system (12) according to one of the preceding claims,
**characterized in that**
the test terminals (24) are arranged on the underside of the testing device (16), wherein the transport devices (14) are positionable underneath the testing device (16), so that, with the assistance of the adapter carrier (34) that are positionable between them in the vertical direction and is populated with the adapters (28), the connector outputs (26) are connectable to the test terminals (24).

6. Modular testing system (12) according to one of the preceding claims,
**characterized in that**
the adapter carrier (34) has holding regions for holding the adapters (28) in a respective testing position and at least one storage region for adapters (28) that are currently not needed.

7. Modular testing system (12) according to Claim 6, **characterized in that**
the modular testing system (12) is configured to automatically select the necessary adapters (28) in a manner suitable for a respective variant of the cable harness (18) to be tested and to position them at the corresponding holding regions.

8. Modular testing system (12) according to one of the preceding claims,
**characterized in that**
the transport devices (14) have holders for holding respective cables of the cable harnesses (18).

9. Modular testing system (12) according to one of the preceding claims,
**characterized in that**
the test terminals (24) of the testing device (16) each have a plurality of electrical terminals for testing the cable harnesses (18).

10. Modular testing system (12) according to one of the preceding claims,
**characterized in that**
the test terminals (24) of the testing device (16) each have at least one pneumatic terminal for testing the connectors (22) of the cable harnesses (18).

11. Modular testing system (12) according to one of the preceding claims,
**characterized in that**
the test terminals (24) of the testing device (16) all have the same standard structure, wherein all the outputs (32) of the different variants of the adapters (28) likewise have a corresponding standard structure.

12. Modular testing system (12) according to one of the preceding claims,
**characterized in that**
the inputs (30) of the different variants of the adapters (28) differ from one another by way of the number and/or arrangement of electrical and/or pneumatic interfaces that are coupleable to the connector outputs (26).

13. Modular testing system (12) according to one of the preceding claims,
**characterized in that**
the modular testing system (12) is configured to couple the testing device (16) automatically to the connectors (22) of the respective cable harness (18) held by means of one of the transport devices (14) with the assistance of the adapter carrier (34).

14. Modular testing system (12) according to one of the preceding claims,
**characterized in that**
the modular testing system (12) is configured to carry out a predefinable testing routine on the corresponding cable harness (18) automatically in the state coupled to the connectors (22) with the assistance of the adapter carrier (34).

15. Method for the automated testing of different variants of cable harnesses (18), in which the respective cable harnesses (18) are picked up from respective building boards (10), transported and tested by means of a modular testing system (12) according to one of the preceding claims.

## Revendications

1. Système de contrôle modulaire (12) permettant de contrôler de façon automatisée différentes variantes de faisceaux de câbles (18), comprenant :
- plusieurs dispositifs de transport (14) conçus pour recevoir et transporter les faisceaux de câbles (18) respectifs disposés sur des planches de construction (10) ;
- différentes variantes de logements de contour (20) pouvant être apportées aux dispositifs de transport (14) pour recevoir les différentes variantes de connecteurs enfichables (22) des faisceaux de câbles (18) ;
- au moins un dispositif de contrôle (16) avec plusieurs bornes de contrôle (24) permettant de raccorder indirectement le dispositif de contrôle (16) aux sorties (26) respectives du connecteur enfichable du connecteur enfichable (22) des faisceaux de câbles (18) ;
- différentes variantes d'adaptateurs (28) permettant de relier le dispositif de contrôle (16) aux différentes variantes des connecteurs enfichables (22) des faisceaux de câbles (18), comportant une entrée (30) respectivement propre à chaque variante permettant d'établir une liaison par enfichage avec les sorties (26) respectives du connecteur enfichable des variantes des connecteurs enfichables (22) et avec une sortie (32) respective permettant d'établir une liaison par enfichage avec les bornes de contrôle (24) du dispositif de contrôle (16) ;
- au moins un support d'adaptateur (34) auquel les différentes variantes des adaptateurs (28) peuvent être raccordées spécifiquement en fonction de chaque faisceau de câbles au niveau des différentes positions du support d'adaptateur (34).

2. Système de contrôle modulaire (12) selon la revendication 1, **caractérisé en ce que** :
le dispositif de transport (14) comporte au moins une plaque de montage à laquelle les logements de contour (20) peuvent être fixés, dans lequel la plaque de montage est disposée au-dessus des planches de construction (10) dans un logement conforme à son utilisation du dispositif de transport (14) afin d'équiper les logements de contour (20) avec les connecteurs enfichables (22) respectifs des faisceaux de câbles (18).

3. Système de contrôle modulaire (12) selon la revendication 1 ou 2, **caractérisé en ce que** :
en cas d'agencement conforme à leur utilisation des logements de contour (20) au niveau du dispositif de transport (14), les connecteurs enfichables (22) des faisceaux de câbles (18) peuvent être enfichés et verrouillés en côté dans le logement de contour (20).

4. Système de contrôle modulaire (12) selon l'une quelconque des revendications précédentes, **caractérisé en ce que** :
en cas de connecteurs enfichables (22) logés de façon conforme à leur utilisation dans les logements de contour (20), les sorties (26) respectives du connecteur enfichable sont orientées vers le haut.

5. Système de contrôle modulaire (12) selon l'une quelconque des revendications précédentes, **caractérisé en ce que** :
les bornes de contrôle (24) sont disposées sur le côté inférieur au niveau du dispositif de contrôle (16), dans lequel les dispositifs de transport (14) peuvent être positionnés en dessous du dispositif de contrôle (16), de sorte que les sorties de connecteur enfichable (26) puissent être reliées aux bornes de contrôle (24) par l'entremise du support d'adaptateur (34) doté des adaptateurs (28) et pouvant être positionné dans la direction verticale.

6. Système de contrôle modulaire (12) selon l'une quelconque des revendications précédentes, **caractérisé en ce que** :
le support d'adaptateur (34) comporte des zones de réception destinées à recevoir les adaptateurs (28) dans une position de contrôle respective ainsi qu'au moins une zone de stockage pour les adaptateurs (28) momentanément non nécessaires.

7. Système de contrôle modulaire (12) selon la revendication 6, **caractérisé en ce que** :
le système de contrôle modulaire (12) est conçu pour sélectionner automatiquement les adaptateurs (28) nécessaires de façon adaptée pour chaque variante respective du faisceau de câbles (18) à contrôler et pour les positionner au niveau des zones correspondantes.

8. Système de contrôle modulaire (12) selon l'une quelconque des revendications précédentes, **caractérisé en ce que** :
les dispositifs de transport (14) comportent des fixations permettant de maintenir les câbles respectifs des faisceaux de câbles (18).

9. Système de contrôle modulaire (12) selon l'une quelconque des revendications précédentes, **caractérisé en ce que** :
les bornes de contrôle (24) du dispositif de contrôle (16) comportent respectivement plusieurs bornes électriques permettant de contrôler les faisceaux de câbles (18).

10. Système de contrôle modulaire (12) selon l'une quelconque des revendications précédentes, **caractérisé en ce que** :
les bornes de contrôle (24) du dispositif de contrôle (16) comportent respectivement au moins un raccord pneumatique permettant de contrôler les connecteurs enfichables (22) des faisceaux de câbles (18).

11. Système de contrôle modulaire (12) selon l'une quelconque des revendications précédentes, **caractérisé en ce que** :
les bornes de contrôle (24) du dispositif de contrôle (16) présentent toutes la même structure standard, dans lequel toutes les sorties (32) des différentes variantes des adaptateurs (28) comportent également une structure standard correspondante.

12. Système de contrôle modulaire (12) selon l'une quelconque des revendications précédentes, **caractérisé en ce que** :
les entrées (30) des différentes variantes des adaptateurs (28) se distinguent les unes des autres par le nombre et/ou l'agencement des interfaces électriques et/ou pneumatiques pouvant être couplées aux sorties de connecteur enfichable (26).

13. Système de contrôle modulaire (12) selon l'une quelconque des revendications précédentes, **caractérisé en ce que** :
le système de contrôle modulaire (12) est conçu pour coupler automatiquement le dispositif de contrôle (16) par l'entremise du support d'adaptateur (34) aux connecteurs enfichables (22) du faisceau de câbles (18) respectif logé à l'aide d'un des dispositifs de transport (14) .

14. Système de contrôle modulaire (12) selon l'une quelconque des revendications précédentes, **caractérisé en ce que** dans l'état couplé aux connecteurs enfichables (22) par l'entremise du support d'adaptateur (34), le système de contrôle modulaire (12) est conçu pour exécuter automatiquement une routine de contrôle pouvant être prédéfinie en présence d'un faisceau de câbles (18) correspondant.

15. Procédé permettant de contrôler de façon automatisée différentes variantes de faisceaux de câbles (18), dans lequel les faisceaux de câbles (18) respectifs sont reçus par des planches de construction (10) respectives, transportés et contrôlés, à l'aide d'un système de contrôle modulaire (12) selon l'une quelconque des revendications précédentes.
